# EUROPÄISCHE PATENTSCHRIFT

(11) **EP 1 083 630 B1**
(45) Veröffentlichungstag und Bekanntmachung des Hinweises auf die Patenterteilung: **07.11.2007**
(21) Anmeldenummer: 00119105.5
(22) Anmeldetag: 04.09.2000
(51) Int. Cl.: H01R 12/20, H01R 13/646

(54) **Koaxial-Steckverbinder**
Coaxial plug connector
Connecteur coaxial à fiche

(30) Priorität: 07.09.1999 DE 19942579
(43) Veröffentlichungstag der Anmeldung: 14.03.2001
(73) Patentinhaber: Harting Electronics GmbH & Co. KG, 32339 Espelkamp (DE)
(72) Erfinder: Harting, Dietmar, Dipl.-Kfm., 32339 Espelkamp (DE); Pape, Günter, Dipl.-Ing., 32130 Enger (DE); Berghorn, Manfred, Dipl.-Ing., 31592 Stolzenau (DE)

(56) Entgegenhaltungen:
- EP-A- 0 555 933
- US-A- 5 791 937

## Beschreibung

Die Erfindung betrifft einen Koaxial-Steckverbinder zur Montage auf einer Leiterplatte mit einem oder mehreren Doppelkoaxialkontakten, die einerseits ein Steckanschlussende und andererseits ein Anschlussende zur Leiterplatte aufweisen und wobei der Koaxialkontakt aus einer elektrisch leitfähigen Außenhülle und einem einteiligen, zur Außenhülle mittels Dielektrikum isolierten, Signalkontakt besteht.

Aus dem Katalog der Fa. Harting "har-pak, High Density Connector System, 26 6, MO/16.10.98/6.0" sind Koaxial-Steckverbinder zur Lötbefestigung auf einer Leiterplatte bekannt, die jedoch nicht für die SMT -Technik ausgebildet sind. Diese Koaxial-Steckverbinder sind mit Einpreßkontakten versehen und die mechanische Befestigung auf der Leiterplatte erfolgt durch Einpreßzapfen.
Aus der Firmenschrift der Fa. Siemens Eine Verbindung, die voller Vorteile steckt, Siemax - der erste Multi Koax-Steckverbinder, Ausgabe: 12/98" sind Koaxial-Steckverbinder zur Befestigung auf Leiterplatten bekannt, die bereits für die SMT - Technik ausgebildet sind.
Hierbei ist vorgesehen, daß der komplette Koaxial-Steckverbinder zum Reflow-löten auf der Leiterplatte positioniert wird. Um die Reflow-Lötbarkeit und die Kontrolle der Lötstelle zu gewährleisten, darf der Signalleiter jedoch nicht komplett geschirmt sein, was wiederum zu einer Begrenzung der Übertragungseigenschaften führt.
Da der Steckverbinder über dem Kartenrand hervorsteht, und die normale Begrenzung, die üblicherweise durch Abmaße der Leiterplatte entsteht, überschritten ist, sind zusätzliche Maßnahmen beim Löten erforderlich.

Das Problem bei Kartenrandsteckverbindern mit SMT-Anschlüssen (SMT = Surface Mounting Technologie) liegt darin, dass die Steck- und Ziehkräfte zum Gegensteckverbinder keinesfalls über die Lötpads geführt werden dürfen, da die Lötpads aufgrund ihrer geringen Haltekräfte von der Leiterplatte reißen werden.
Vielmehr sind besondere Vorkehrungen zu treffen, um die Kartenrandsteckverbinder mechanisch solide mit der Leiterplatte zu verbinden.

Der Erfindung liegt nun die Aufgabe zugrunde, einen Koaxial-Steckverbinder der eingangs genannten Art dahingehend auszubilden, dass zumindest die Signalkontakte mit SMT-Anschlüssen versehen sind und ein automatischer Standard-Bestückungsprozeß ermöglicht wird, ohne dass besondere Maßnahmen bezüglich eines Kartenrandsteckverbinders getroffen werden müssen.
Außerdem soll eine sichere und dauerhafte Kontaktgabe auch bei Erwärmung durch unterschiedliche Ausdehnungskoeffizienten im Betrieb gewährleistet und der Koaxial-Steckverbinder trotzdem mechanisch fest auf der Leiterplatte fixiert sein.
Des Weiteren sollen die Signalkontakte für höherer Übertragungsgeschwindigkeiten komplett geschirmt sein.

Diese Aufgabe wird dadurch gelöst, dass das Anschlussende eines Signalkontaktes steckerförmig ausgebildet ist, und dass das Anschlussende in eine auf einer Leiterplatte gehaltene und mit dieser elektrisch verbundenen Kontaktbuchse eintaucht, wobei der Signalkontakt elektrisch leitend mit der Leiterplatte verbunden ist.

Vorteilhafte Ausgestaltungen der Erfindung sind in den Ansprüchen 2 -10 angegeben.

Die mit der Erfindung erzielten Vorteile bestehen insbesondere darin, daß der Koaxial-Steckverbinder aufgrund der guten Abschirmwirkung auch höherfrequente Signale sicher überträgt.
Die verbesserte Abschirmung beruht auf der Tatsache, dass die Abschirmung des gesamten Koaxial-Steckverbinders geschlossen bis auf der Leiterplatte herunter reicht.
Des Weiteren kann eine Bestückung der Leiterplatte mit dem als Kartenrandsteckverbinder ausgebildeten Koaxial-Steckverbinder, sowie das nachfolgende Reflow-Löten vollautomatisch und ohne besondere Vorsichtsmaßnahmen erfolgen, wobei die visuelle Überprüfung der Lötstellen stark vereinfacht wird, da die Lötstellen auf der Leiterplatte direkt zugänglich sind. Eine verbesserte Montage des Koaxial-Steckverbinders ergibt sich aus der Unterteilung des Koaxial-Steckverbinders in ein Kontaktträgergehäuse mit den Doppelkoaxialkontakten und einem Trägerrahmen mit Kontaktbuchsen, mittels denen die lötbaren Signalkontakte auf der Leiterplatte fixiert werden. Ein wesentlicher Vorteil dieser Erfindung liegt in der sicheren und dauerhaften Kontaktgabe auch bei unterschiedlicher Materialausdehung von Koaxial-Steckverbinder und Leiterplatte im Betrieb durch die Ausgleichsmöglichkeiten des als Kugelkopf ausgebildeten Kontaktendes des Signalkontaktes in den entsprechend geformten Kontaktbuchsen.
Eine gute mechanischen Festigkeit ist zudem gewährleistet, weil die Signalkontakte und das Kontaktträgergehäuse unabhängig voneinander auf der Leiterplatte fixiert sind.

Ein Ausführungsbeispiel der Erfindung ist in der Zeichnung dargestellt und wird im folgenden näher erläutert. Es zeigen:
- Fig. 1: eine Ansicht eines montierten Koaxial-Steckverbinders auf einer Leiterplatte,
- Fig. 2: eine Ansicht eines noch nicht montierten Koaxial-Steckverbinders auf einer mit einemTrägerrahmen versehenen Leiterplatte,
- Fig. 3: eine auseinandergezogene Ansicht mit einer Leiterplatte, einem Trägerrahmen und einem Kontaktträgergehäuse mit Doppelkoaxialkontakten,
- Fig. 4: eine vergrößerte Darstellung des Trägerrahmens,
- Fig. 5: eine Schnittdarstellung eines abgewinkelten Koaxial-Steckverbinders,
- Fig. 6: eine vergrößerte Darstellung eines Signalkontaktendes in einer Kontaktbuchse,
- Fig. 7: eine vergrößerte Darstellung eines schief ausgerichteten Signalkontaktendes in einer Kontaktbuchse,
- Fig. 8: eine vergrößerte perspektivische Darstellung eines Doppelkoaxialkontaktes,
- Fig. 9: mehrere Anschlußvarianten von Kontaktbuchsen,
- Fig. 10: eine Schnittdarstellung eines geraden Koaxial-Steckverbinders, und
- Fig. 11: eine auseinandergezogene perspektivische Darstellung eines geraden Koaxialkontaktes.

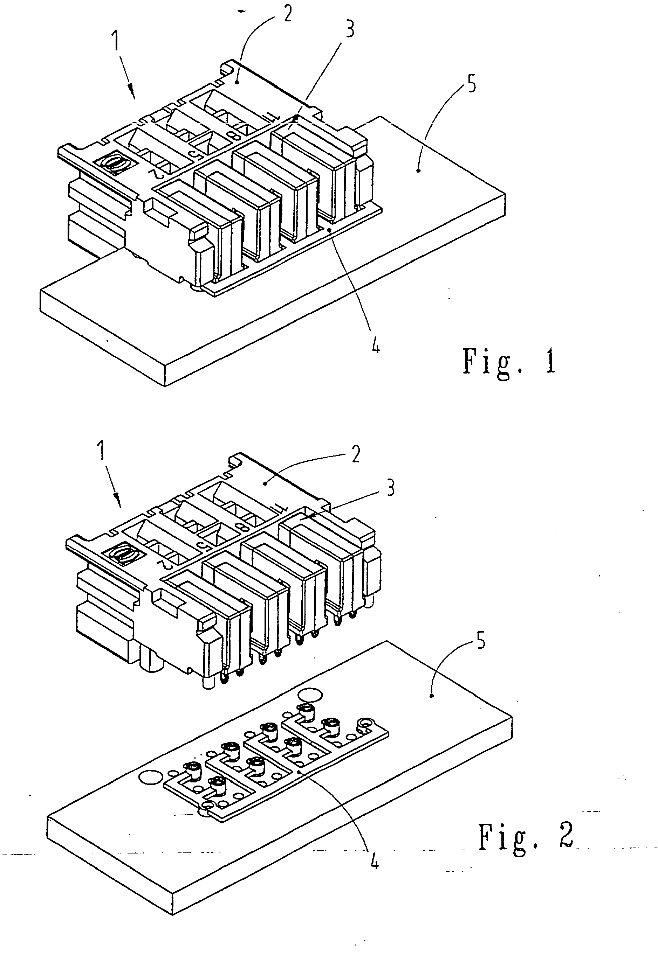

Die Fig. 1 zeigt in einer perspektivischen Ansicht einen Koaxial-Steckverbinder 1, der als sogenannter Kartenrandsteckverbinder ausgebildet ist und bei dem mehrere Doppelkoaxialkontakte 3 in einem Kontaktträgergehäuse 2 angeordnet sind und zusammen mit einem zwischengelegten Trägerrahmen 4 auf einer Leiterplatte 5 montiert ist.

In der Fig. 2 ist ein bereits auf der Leiterplatte 5 montierten Trägerrahmen 4 gezeigt, auf den in einem weiteren Arbeitsgang das Kontaktträgergehäuse 2 mit den Doppelkoaxialkontakten 3 zu montieren ist.

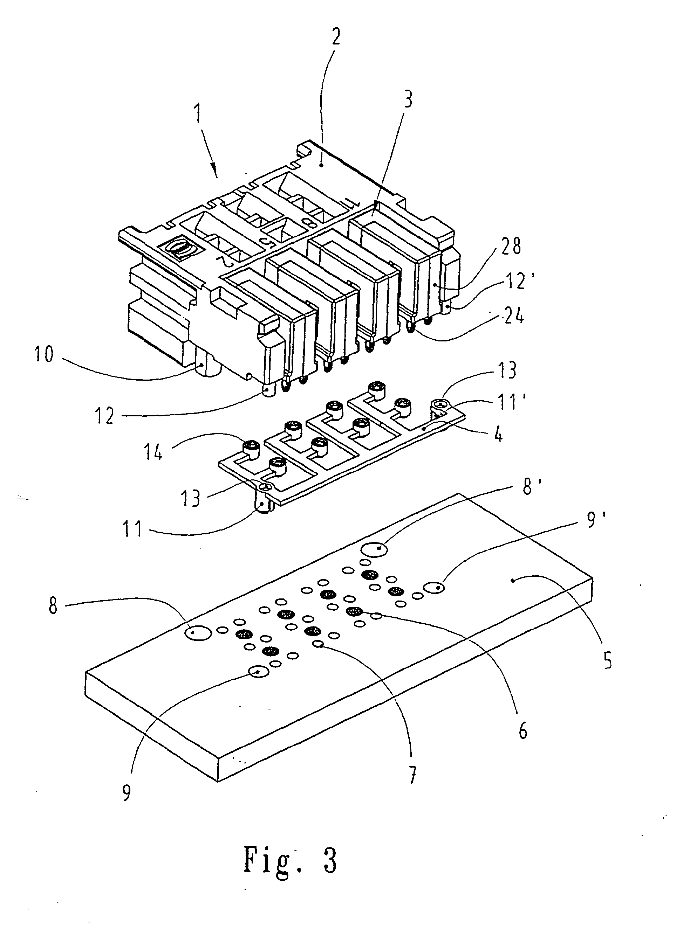

In der Fig. 3 sind in einer auseinandergezogenen Darstellung die unterschiedlichen Bauelemente: Leiterplatte 5, Trägerrahmen 4 sowie der Koaxial-Steckverbinder 1 mit dem Kontaktträgergehäuse 2 und den darin gehaltenen Doppelkoaxialkontakten 3 dargestellt.
Auf der Leiterplatte 5 ist das für die Montage eines Koaxial-Steckverbinders erforderliche Steckgesicht mit den Lötpads 6 und den Bohrungen 7, 8, 9 ersichtlich.
Bei der Montage des Koaxial-Steckverbinders wird zunächst der Trägerrahmen 4 mit den Positionierhülsen 11 und 11' in den Bohrungen 9 und 9' auf der Leiterplatte 5 positioniert, wodurch zwangsweise die in den Aufnahmehülsen 15 an den Verbindungsstegen 16 des Trägerrahmens 4 gehaltenen Kontaktbuchsen 14 auf die Lötpads 6 aufsetzen.
In diesem Montagezustand wird der Trägerrahmen 4 mit den in den Aufnahmehülsen 15 gehaltenen Kontaktbuchsen 14 mit der Leiterplatte 5 in einem Reflow-Lötbad miteinander verbunden.
Die Montage des Kontaktträgergehäuses 2 mit den darin eingesetzten Doppelkoaxialkontakten 3 erfolgt im Anschluß an den Lötvorgang.
Dabei wird das Kontaktträgergehäuse 2 in einem Arbeitsgang mit den Einpreßzapfen 10 in die Bohrungen 8 und 8' der Leiterplatte eingepreßt, während die zusätzlichen Befestigungszapfen 12 und 12' in die Öffnung 13 der Positionierhülsen 11 und 11' des Trägerrahmens 4 eingefügt werden. Weiterhin pressen sich die Außenkontaktanschlüsse 24 im Bodenbereich 26 der Doppelkoaxialkontakte 3 in die dazu vorgesehenen Bohrungen 7 in der Leiterplatte 5, um die abschirmende Wirkung einer aus einer Außenkontakthülse 28 und einem Außenkontaktkörper 29 bestehenden Außenhülle an das Massepotential der Leiterplatte 5 zu übertragen.

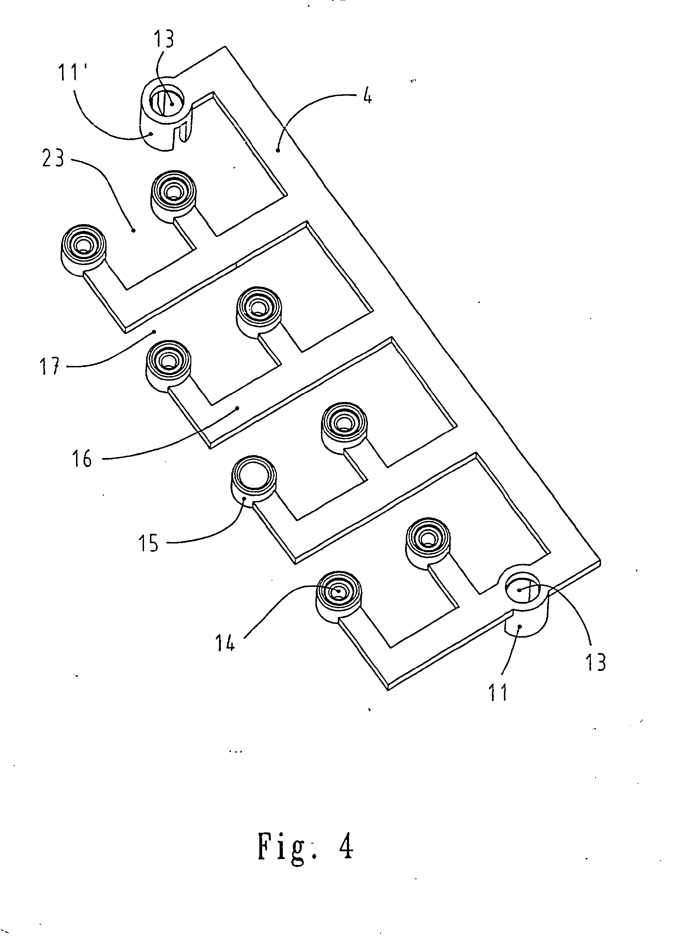

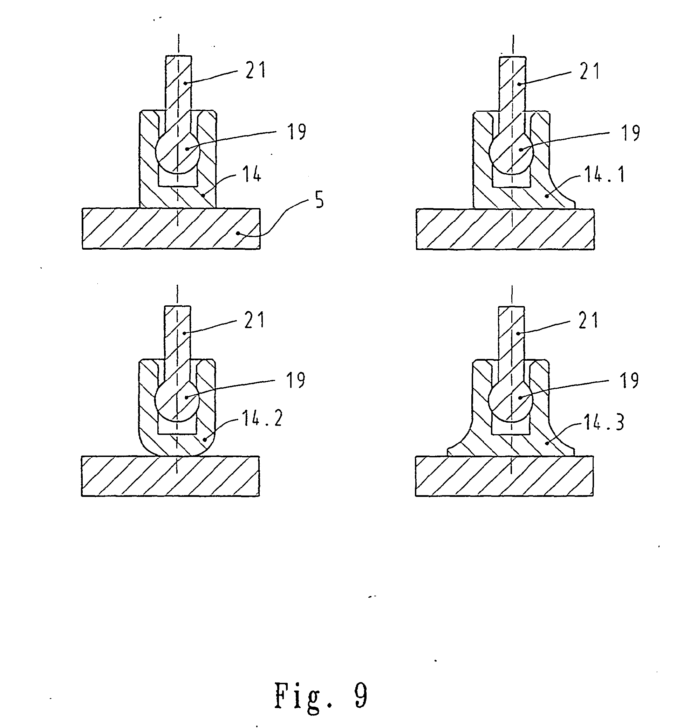

Die Fig. 4 zeigt in einer vergrößerten Darstellung den Trägerrahmen 4 mit kamm-ähnlich ausgeführten Verbindungsstegen 16, an denen die (in Fig. 9 näher erläuterten) Kontaktbuchsen 14 in entsprechenden Aufnahmehülsen 15 eingelassen sind.
Weiterhin sind die zur Positionierung auf der Leiterplatte 5 vorgesehenen Positionierhülsen 11 mit Öffnungen 13 versehen, wobei der untere Teil der Positionierhülsen in Längs- bzw. in Querrichtung geschlitzt ist, um eventuelle Positionsabweichungen zwischen Trägerrahmen und Leiterplatte auszugleichen.
Die Anordnung der Verbindungsstege in dieser kamm-ähnlichen Art bietet den Vorteil, dass die dadurch entstehenden Freiräume 17 und 23 für eine masseführende Abschirmung zwischen den einzelnen Kontakten auf der Leiterplatte nutzbar sind.

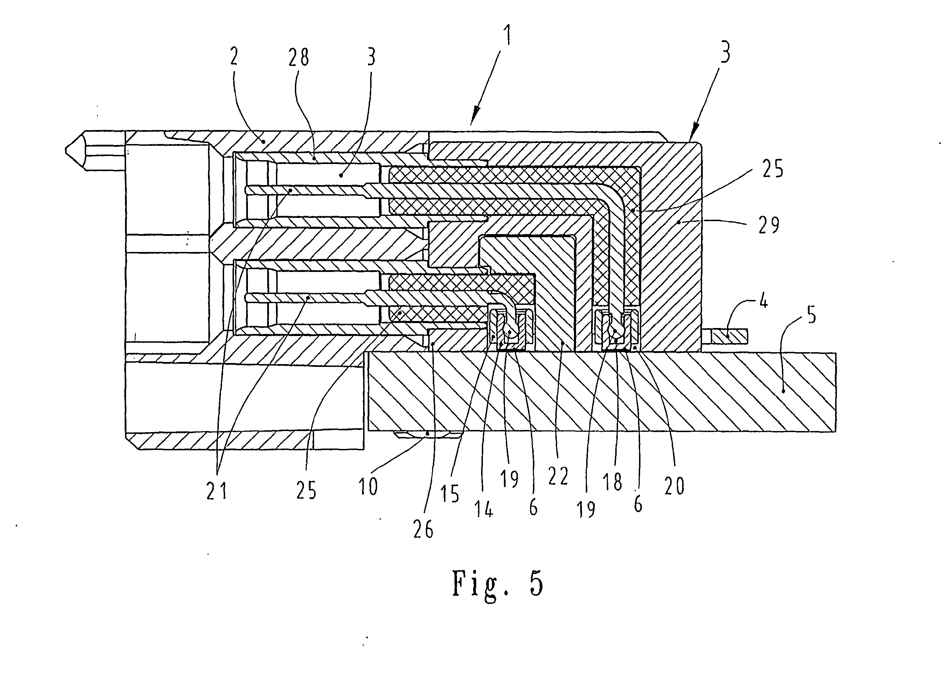

Der komplette Aufbau eines abgewinkelten Koaxial-Steckverbinders 1 montiert auf einer Leiterplatte 5 ist in einer Schnittdarstellung der Fig. 5 dargestellt.
In dem Kontaktträgergehäuse 2 ist ein Doppelkoaxialkontakt 3 mit zwei Signalkontakten 21 vorgesehen, die elektrisch isoliert von der Außenhülle, jeweils in einem Dielektrikum 25 eingebettet sind.
Die Außenhülle wird aus dem Außenkontaktkörper 29 und den Außenkontakthülsen 28 gebildet, die elektrisch leitend verbunden sind.
Die kugelförmigen Enden 19 der beiden Signalkontakte 21 sind in den Kontaktbuchsen 14 elektrisch leitend über die Lötpads 6 mit der Leiterplatte 5 verbunden, wobei die Kontaktbuchsen 14 in den Aufnahmehülsen 15 des Trägerrahmens 4 auf der Leiterplatte 5 gehalten sind.
Unterhalb der Aufnahmehülsen 15 ist für das bei Erwärmung fließende Lot ein Freiraum 20 vorgesehen.
Die Abschirmung insgesamt umfaßt das Kontaktträgergehäuse 2, die Au-ßenkontakthülsen 28, den Außenkontaktkörper 29, sowie zwischen den beiden Signalkontakten 19 den Abschirmbalken 22 und reicht bis in den Bodenbereich 26 auf die Oberfläche der Leiterplatte 5 herunter, wobei die Übertragung durch die Außenkontaktanschlüsse 24 auf Leiterbahnen der Leiterplatte erfolgt.

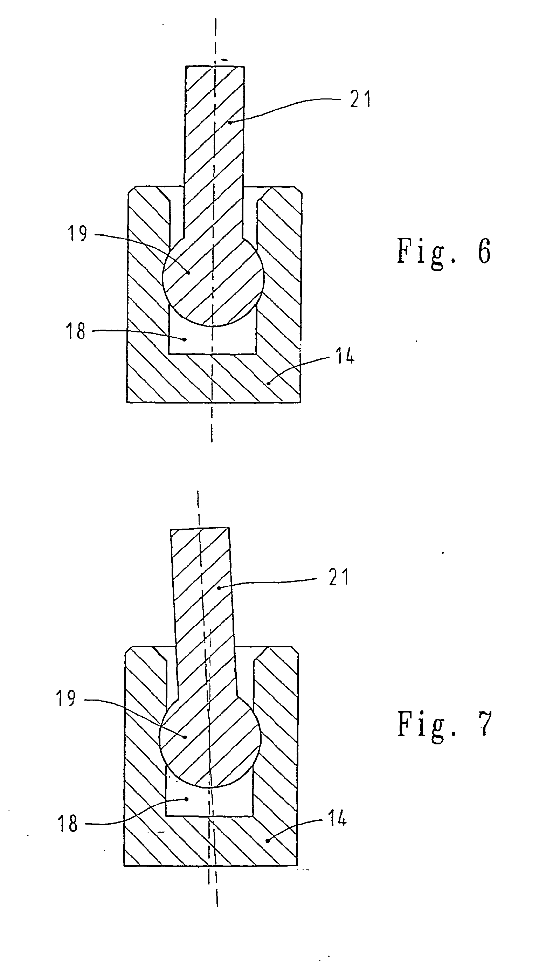

In der Fig. 6 ist in einer stark vergrößerten Schnittdarstellung gezeigt, wie ein als Kugelkopf 19 ausgeführtes Kontaktende eines Signalkontaktes 21 in die Ausnehmung 18 einer Kontaktbuchse 14 eingefügt ist.
Eine eventuelle Fehlanpassung, wie in Fig. 7 dargestellt, wird durch die kugelförmige Ausführung des Signalkontaktes weitgehend kompensiert, so dass von den Signalkontakten 21 auf die Kontaktbuchse 14 auftretende Drehmomente und Scherkräfte vermieden werden.

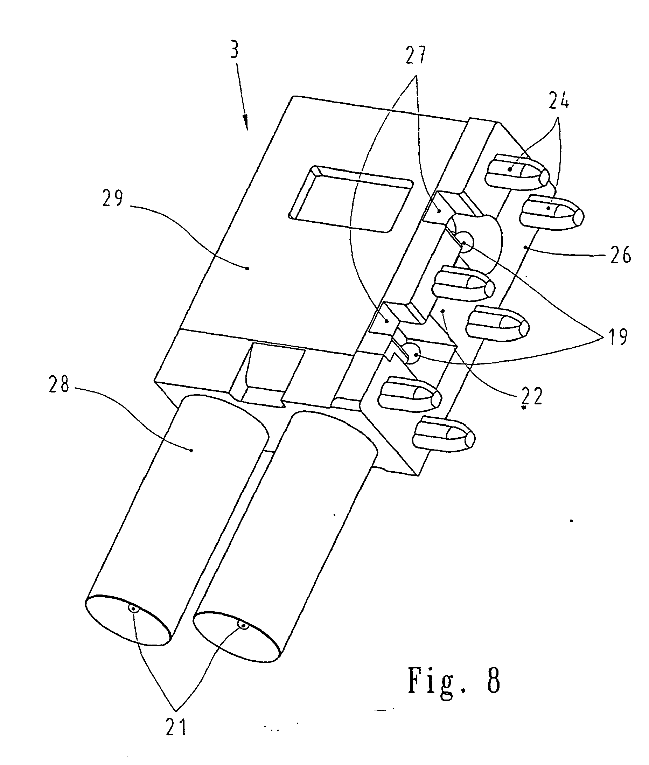

Die Fig. 8 zeigt in einer Vergrößerung eine perspektivische Ansicht eines einzelnen Doppelkoaxialkontaktes 3 aus der Sicht der Kontaktanschlüsse. Innerhalb des als abschirmendes Gehäuse ausgeführten Außenkontaktkörpers 29 und den daran elektrisch leitend angefügten Außenkontakthülsen 28 sind die Signalkontakte 21 angeordnet, die mit ihren kugelförmigen Enden 19 in den Bodenbereich 26 hineinragen.
Die mechanische Befestigung des Doppelkoaxialkontaktes wird von den Außenkontaktanschlüssen 24 übernommen, die in entsprechende Bohrungen 7 auf der Leiterplatte 5 eingepreßt werden.
Um ein dichtes Aufsetzen des Koaxialkontaktes 3 auf der Leiterplatte zu gewährleisten und damit eine gute abschirmende Wirkung zu erzielen, sind an den Längsseitenwänden des Außenkontaktkörpers 29 Ausnehmungen 27 vorgesehen, in die die Verbindungsstege 16 des Trägerrahmens 4 bei der endgültigen Montage einfügbar sind.

In der Fig. 9 sind Kontaktbuchsen 14, 14.1, 14.2, 14.3 mit unterschiedlich geformten Außenkonturen dargestellt, die für eine Aufnahme der Signalkontakte 21 - und hier speziell der Kugelkopfenden 19 - vorgesehen sind. Die Kontaktbuchsen 14 werden normalerweise in den Aufnahmehülsen 15 eines Trägerrahmens 4 gehalten.
In einer Variante kann der Trägerrahmen 4 mit den Aufnahmehülsen 15 nach dem Lötvorgang von der Leiterplatte entfernt werden, so daß die Kontaktbuchsen 14 auf der Leiterplatte zurückbleiben.

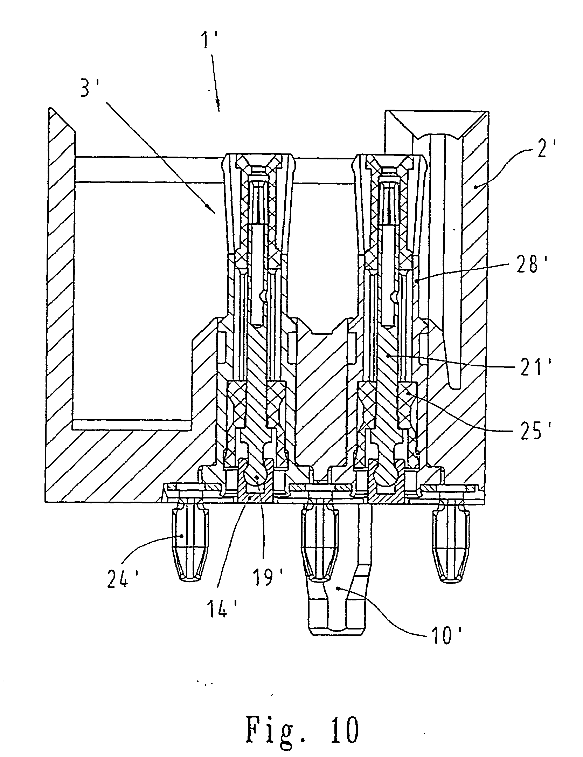

In der Fig. 10 ist ein modifizierter Koaxial-Steckverbinder 1' gezeigt, der nicht als gewinkelter, sondern in einer - bezogen auf die Signalkontakte 21' - geraden Version ausgeführt ist.

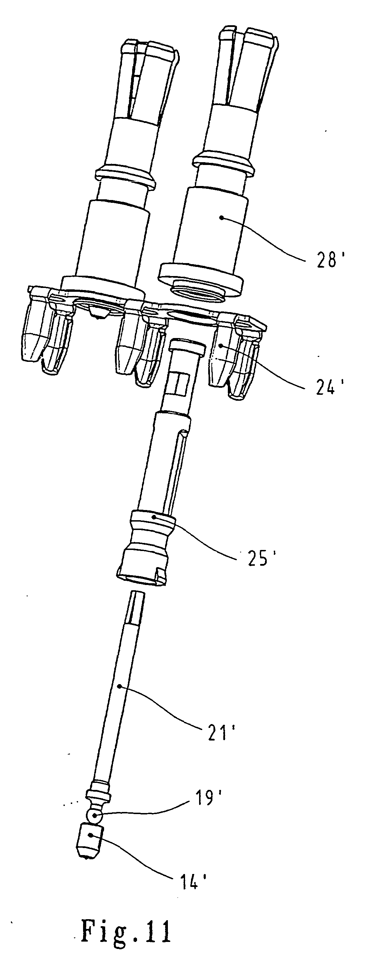

In der Fig. 11 sind in einer auseinandergezogenen perspektivischen Darstellung die inneren, signalführenden Teile gezeigt, die in ihrem Aufbau dem bereits beschriebenen Ausführungsbeispiel entsprechen.

Die in den beiden Figuren 10 und 11 verwendeten Bezugszeichen gleichen den bereits für den gewinkelten Koaxial-Steckverbinder verwendeten, sind jedoch zur Unterscheidung mit einem Hochzeichen versehen.

## Patentansprüche

1. Koaxial-Steckverbinder (1) zur Montage auf einer Leiterplatte (5), mit einem oder mehreren Doppelkoaxialkontakten (3), die einerseits ein Steckanschlussende und andererseits ein Anschlussende zur Leiterplatte aufweisen und wobei der Koaxialkontakt (3) aus einer elektrisch leitfähigen Außenhülle (28, 29) und einem einteiligen, zur Außenhülle mittels Dielektrikum (25) isolierten, Signalkontakt (21) besteht, **dadurch gekennzeichnet,**
**dass** das Anschlussende eines Signalkontaktes (21) steckerförmig ausgebildet ist, und
**dass** das Anschlussende in eine auf einer Leiterplatte (5) gehaltene und mit dieser elektrisch verbundenen Kontaktbuchse (14) eintaucht, wobei der Signalkontakt (21) elektrisch leitend mit der Leiterplatte verbunden ist.

2. Koaxial-Steckverbinder nach Anspruch 1, **dadurch gekennzeichnet, dass** das Anschlussende des Signalkontaktes (21) als Kugelkopf (19) ausgebildet ist.

3. Koaxial-Steckverbinder nach Anspruch 1 oder 2, **dadurch gekennzeichnet,**
**dass** die Kontaktbuchsen (14) in Aufnahmehülsen (15) eines aus isolierendem Material ausgebildeten Trägerrahmens (4) gehalten sind.

4. Koaxial-Steckverbinder nach einem der vorstehenden Ansprüche, **dadurch gekennzeichnet,**
**dass** die Kontaktbuchsen (14) unterschiedliche Ausführungen (14.1,14,2,14.3) zum elektrischen Übergang auf die Leiterplatte (5) aufweisen.

5. Koaxial-Steckverbinder nach einem der vorstehenden Ansprüche, **dadurch gekennzeichnet,**
**dass** am Trägerrahmen (4) Positionierhülsen (11, 11') angeformt sind, die zur Positionierung in entsprechende Bohrungen (8, 8') in der Leiterplatte (5) eintauchen.

6. Koaxial-Steckverbinder nach einem der vorstehenden Ansprüche, **dadurch gekennzeichnet,**
**dass** die Positionierhülsen (11, 11') am Trägerrahmen (4), Öffnungen (13) aufweisen, in die Befestigungszapfen (12, 12') des Kontaktträgergehäuses (2) greifen, und
**dass** die Positionierhülsen (11, 11') an ihrer Steckseite geschlitzt sind.

7. Koaxial-Steckverbinder nach einem der vorstehenden Ansprüche,
**dadurch gekennzeichnet,**
**dass** die Kontaktbuchsen (14) fest mit dem Trägerrahmen (4) verbunden sind.

8. Koaxial-Steckverbinder nach einem der vorstehenden Ansprüche,
**dadurch gekennzeichnet,**
**dass** die Kontaktbuchsen (14) lösbar vom Trägerrahmen (4) ausgebildet sind.

9. Koaxial-Steckverbinder nach einem der vorstehenden Ansprüche,
**dadurch gekennzeichnet,**
**dass** die Verbindungsstege (16) des Trägerrahmens (4) in Ausnehmungen (27) im Bodenbereich (26) des Koaxialkontaktes (3) einfügbar sind.

10. Koaxial-Steckverbinder nach einem der vorstehenden Ansprüche,
**dadurch gekennzeichnet,**
**dass** die elektrisch leitende Außenhülle eines Doppelkoaxialkontaktes (3) aus einem Außenkontaktkörper (29), mindestens einer Außenkontakthülse (28) und Außenkontakten (24) gebildet ist.

## Claims

1. A coaxial plug connector (1) for mounting on a printed circuit board (5), comprising one or more dual coaxial contacts (3) which, at one side, have a plug-in connection end and, at the other side, an end for connection to the printed circuit board, and the coaxial contact (3) consisting of an electrically conductive outer jacket (28, 29) and a one-piece signal contact (21) which is insulated from the outer jacket by means of a dielectric (25), **characterized in that**
the connection end of a signal contact (21) is designed to have a plug shape, and
the connection end plunges into a contact socket (14) which is held on a printed circuit board (5) and is electrically connected to the latter, the signal contact (21) being electrically conductively connected to the printed circuit board.

2. The coaxial plug connector according to claim 1, **characterized in that**
the connection end of the signal contact (21) is in the form of a spherical head (19).

3. The coaxial plug connector according to claim 1 or 2, **characterized in that** the contact sockets (14) are held in receiving sleeves (15) of a carrier frame (4) formed of an insulating material.

4. The coaxial plug connector according to any of the preceding claims,
**characterized in that**
the contact sockets (14) have different configurations (14.1, 14.2, 14.3) for the electric transition to the printed circuit board (5).

5. The coaxial plug connector according to any of the preceding claims,
**characterized in that**
integrally formed with the carrier frame (4) are positioning sleeves (11, 11') which plunge into corresponding bore holes (8, 8') in the printed circuit board (5) for positioning purposes.

6. The coaxial plug connector according to any of the preceding claims,
**characterized in that**
the positioning sleeves (11, 11') on the carrier frame (4) have openings (13) into which fastening pins (12, 12') of the contact carrier housing (2) engage, and
the positioning sleeves (11, 11') are slit on their respective plug-in side.

7. The coaxial plug connector according to any of the preceding claims,
**characterized in that**
the contact sockets (14) are firmly connected with the carrier frame (4).

8. The coaxial plug connector according to any of the preceding claims,
**characterized in that**
the contact sockets (14) are designed to be detachable from the carrier frame (4).

9. The coaxial plug connector according to any of the preceding claims,
**characterized in that**
the connecting webs (16) of the carrier frame (4) can be inserted into recesses (27) in the bottom region (26) of the coaxial contact (3).

10. The coaxial plug connector according to any of the preceding claims,
**characterized in that**
the electrically conductive outer jacket of a dual coaxial contact (3) is formed of an outer contact body (29), at least one outer contact sleeve (28), and outer contacts (24).

## Revendications

1. Connecteur coaxial à fiches (1) destiné à être monté sur une carte de circuits imprimés (5), comportant un ou plusieurs doubles contacts coaxiaux (3) qui présentent d'une part une extrémité d'enfichage embrochable et d'autre part une extrémité de connexion à la carte de circuits imprimés, et le contact coaxial étant constitué par une gaine (28, 29) extérieure électroconductrice et par un contact de signalisation (21) en une pièce, isolé par rapport à la gaine extérieure au moyen d'un diélectrique (25), **caractérisé en ce que**
l'extrémité de connexion d'un contact de signalisation (21) est réalisé sous forme de prise mâle, et
**en ce que** l'extrémité de connexion plonge dans une prise femelle de contact (14) maintenue sur une carte de circuits imprimés (5) et reliée électriquement avec celle-ci, le contact de signalisation (21) étant relié de manière électroconductrice à la carte de circuits imprimés.

2. Connecteur coaxial à fiches selon la revendication 1, **caractérisé en ce que** l'extrémité de connexion du contact de signalisation (21) est réalisé sous forme de tête sphérique (19).

3. Connecteur coaxial à fiches selon la revendication 1 ou 2, **caractérisé en ce que**
les prises femelles de contact (14) sont maintenues dans des douilles de réception (16) d'un cadre porteur (4) réalisé en matériau isolant.

4. Connecteur coaxial à fiches selon l'une des revendications précédentes,
**caractérisé en ce que**
les prises femelles de contact (14) présentent différentes réalisations (14.1, 14.2, 14.3) pour le passage électrique sur la carte de circuits imprimés (5).

5. Connecteur coaxial à fiches selon l'une des revendications précédentes,
**caractérisé en ce que**
sur le cadre porteur (4) sont conformées des douilles de positionnement (11, 11') qui, pour le positionnement, plongent dans des perçages (8, 8') correspondants dans la carte de circuits imprimés (5).

6. Connecteur coaxial à fiches selon l'une des revendications précédentes,
**caractérisé en ce que**
les douilles de positionnement (11, 11') sur le cadre porteur (4) présentent des ouvertures dans lesquelles s'engagent des tenons de fixation (12, 12') du boîtier porteur de contacts (2), et
**en ce que** les douilles de positionnement (11, 11') sont fendues sur leur côté enfichage.

7. Connecteur coaxial à fiches selon l'une des revendications précédentes,
**caractérisé en ce que**
les prises femelles de contact (14) sont reliées de manière solidaire avec le cadre porteur (4).

8. Connecteur coaxial à fiches selon l'une des revendications précédentes,
**caractérisé en ce que**
les prises femelles de contact (14) sont réalisées amovibles du cadre porteur (4).

9. Connecteur coaxial à fiches selon l'une des revendications précédentes,
**caractérisé en ce que**
les traverses de liaison (16) du cadre porteur (4) peuvent être insérées dans des évidements (27) dans la région de fond (26) du contact coaxial (3).

10. Connecteur coaxial à fiches selon l'une des revendications précédentes,
**caractérisé en ce que**
la gaine extérieure électroconductrice d'un double contact axial (3) est formée à partir d'un corps de contact extérieur (29), d'au moins une prise femelle de contact extérieure (28) et de contacts extérieurs (24).
